Europäisches Patentamt

**European Patent Office**

Office européen des brevets

(19)

(11) Numéro de publication: **0 178 225**
**B1**

(12)

# FASCICULE DE BREVET EUROPEEN

(45) Date de publication du fascicule du brevet: **16.08.90**

(51) Int. Cl.⁵: **H 05 K 3/34,** B 65 H 9/00

(21) Numéro de dépôt: **85401942.9**

(22) Date de dépôt: **04.10.85**

(54) **Système de positionnement à barres de type magnétique.**

(30) Priorité: **09.10.84 FR 8415475**

(43) Date de publication de la demande:
**16.04.86 Bulletin 86/16**

(45) Mention de la délivrance du brevet:
**16.08.90 Bulletin 90/33**

(84) Etats contractants désignés:
**AT BE CH DE FR GB IT LI LU NL SE**

(56) Documents cités:
**EP-A-0 172 049**
**GB-A-2 163 987**
**US-A-4 358 198**
**US-A-4 489 923**

(73) Titulaire: **Toniazzo épouse Tokarczyk, Joséphine**
**15 Rue des Roses**
**F-92160 Antony (FR)**
(73) Titulaire: **Remy, Jacques**
**15 Rue des Roses**
**F-92160 Antony (FR)**

(72) Inventeur: **Toniazzo épouse Tokarczyk,**
**Joséphine**
**15 Rue des Roses**
**F-92160 Antony (FR)**
Inventeur: **Remy, Jacques**
**15 Rue des Roses**
**F-92160 Antony (FR)**

Courier Press, Leamington Spa, England.

## Description

La présente invention se rapporte au domaine général du positionnement des pièces (cf. par exemple US—A—4489923) et plus particuliérement à celui rencontré dans la mise en oeuvre des circuits imprimés recevant des composants électroniques.

On connait bien cette technologie dans laquelle les composants sont tout d'abord positionnés par leur queues de soudage ad hoc dans des trous correspondants du circuit imprimé puis l'ensemble ainsi constitué, est rendu homogène tant au plan mécanique qu'électrique par soudage des queues le plus souvent à l'étain; cette opération pouvant être effectuée soit à la vague soit par fusion de la soudure prédisposée.

Dans les processus antérieurs, les circuits imprimés sont positionnés en leurs bords latéraux sur des barres s'assemblage le plus souvent en bois, dont l'écartement était réglé à partir de tiges filetées et d'écrous.

Un tel procédé de positionnement est long et délicat à mettre en oeuvre car il est nécessaire de procèder à l'ajustement de l'écartement de chaque circuit imprimé par une opération fastidieuse de vissage et/ou dévissage des écrous sur les tiges filetées traversant les barres.

Ces opérations étaient nécessaires à chaque changement de format de circuit d'ou des pertes de temps appréciables.

Les demandeurs aprés avoir constaté ces inconvénients, proposent un dispositif de positionnement à barres de type magnétique selon la revendication 1.

L'utilisation de telles barres élimine radicalement les inconvénients cités et apporte un confort inconnu pour les opérateurs car la mise en place obtenue par glissement des barres sur le socle est instantannée et le positionnement peut encore être facilité par des marques de repérage prétracées sur le socle.

En outre les barres selon l'invention peuvent être non parallèles ou bien non rectilignes ce qui peut faciliter certaines conformations de circuit imprimé particulier.

L'invention sera de toutes manières bien comprise dans la suite du texte qui va donner à titre d'exemple et à l'appui des dessins annexés, une forme de réalisation prise dans le domaine de l'implantation des composants sur circuit imprimé.

Sur les dessins:

la figure 1 est une vue schématique en perspective montrant en coupe la disposition de deux barres selon l'invention sur un socle ferromagnétique et recevant un circuit imprimé avec ses composants électroniques.

La figure 2 est une vue schématique en perspective montrant une implantation éventuelle de circuits imprimés avec leurs barres correspondantes sur le socle ferromagnétique qui peut être amovible.

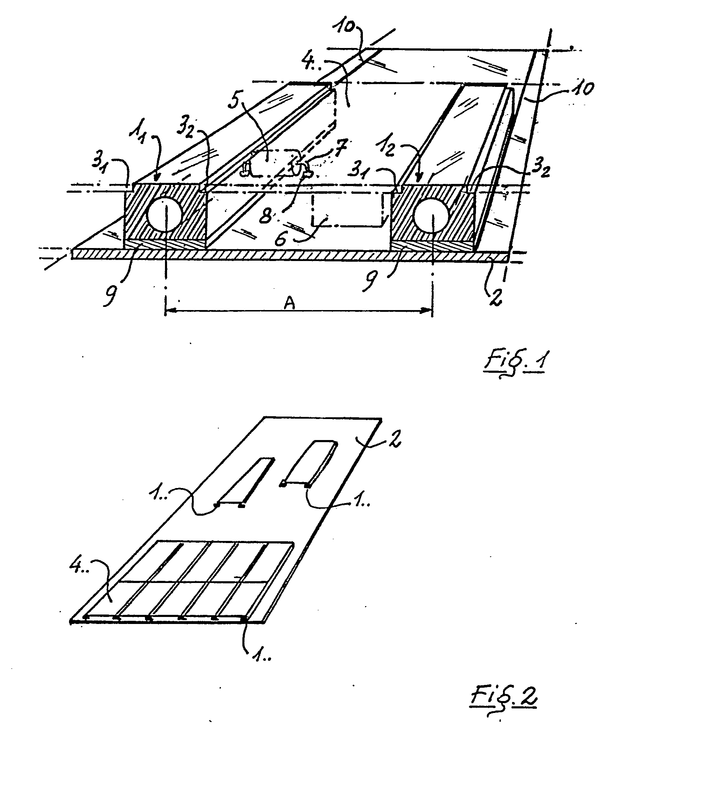

La figure 1 montre comment l'invention peut être utilisée pour des circuits imprimés supportant des composants électroniques, par la mise en oeuvre conjointe d'au moins deux barres de type aimanté repérées $1_1$ et $1_2$ avec un socle ferromagnétique repéré 2.

Chaque barre élémentaire repérée 1, présente une section sensiblement quadrangulaire et sa longueur est déterminée en fonction des besoins exprimés par simple sectionnement.

Dans la forme d'exécution préférée pour circuit imprimé chaque barre 1.. présente deux redans longitudinaux repérés $3_1$ et $3_2$ ce qui fait que le circuit imprimé repéré 4 sur la figure 1 peut comporter comme cela est connu, des composants à queues soudables tels que 5 par exemple dont lesdites queues 7 sont introduites dans les trous 8 au cour de l'opération d'assemblage intéréssée dans l'invention.

L'operatin de soudage proprement dite est effectuée ultérieurement soit par la méthode dite "a la vague" ou encore par d'autres methodes telles que celle de la soudure prédisposée.

Chaque barre 1.. est essentiellement constituée d'une matière souple pouvant être allégée par des cannaux longitudinaux qui peuvent être par exemple circulaires.

Chacune de ces barres est munie sur la face opposée aux redans, d'une semelle magnétique fixée de manière convenable per adhésion par exemple sur chaque barre.

On voit sur la figure 1 que ces barres sont plaquées magnétiquement sur le socle 2 en assurant de manière rigoureuse l'enserrement du circuit 4 et le respect de l'entr'axe A qui peut par ailleurs être prédéterminé par la mise en alignement sur des marques prédisposées 10.

Dans le cas présentement choisi pour des circuits imprimés, chaque barre présente une largeur d'environ 20 mm une hauteur d'environ 15 mm, et la bande magnétique autoadhésive 9 a une épaisseur approximative de 1,6 mm tandis que les redans 3.. ont une section d'environ 1,5×1,5 mm.

La matière utilisée est du PVC chargée en plastifiant et le socle 2 est en acier.

Ce socle 2 peut être amovible ou non et recevoir une grande diversité de barres dans des conformations variées telles que non parallèles, non rectilignes ou autres tel que cela ressort de la figure 2.

Chaque socle peut même être de toute dimension ou de dimension standard compatible avec la console de travail ergonomique à plateaux mobiles verticalement telle que celle ressortissant du EP—A—0172049.

Il est à noter le gain de place résultant de l'invention du fait de l'étroitesse des barres et de leur double usage de support par la présence des deux redans 3.

La hauteur des barres est prévue afin de laisser le passage des éléments inférieures 6 tels que des connecteurs par exemple.

L'exemple présentement donné concerne des circuits imprimés mais il est évident à cet égard, que tout système équivalent pourrait être traité par l'invention tel que du petit matériel d'horlogerie par exemple.

De même cet exemple indique en tant que semelle magnétique une bande autoadhésive et il est non moins évident que tout autre système équivalent tel que par plots magnétiques enrobés dans les barres, pourrait convenir sans sortir de l'invention.

**Revendications**

1. Systéme de positionnement à barres de type magnétique plaquées sur un socle ferro-magnétique notamment pour des composants électroniques disposés sur des circuits imprimés, caractérisé en ce qu'il comporte au moins deux barres (1.1, 1.2...) munies d'une part, de redans latéraux (3.1, 3.2) destinés à recevoir les cotés latéraux d'au moins un circuit imprimé (4) et d'autre part, une semelle disposée sur la face opposée à celle comportant les redans et constituant un dispositif magnétique d'application (9) assurant l'assujettissement magnétique sur le socle ferro-magnétique (2).

2. Systéme de positionnement à barres de types magnétique notamment pour des composants électroniques disposés sur des circuits imprimés selon la revendication 1, caractérisé en ce que chacune des barres recoit le dispositif magnétique (9) par autoadhésion lorsqu'il se présente sous forme de bande.

3. Systéme de positionnement à barres de types magnétique notamment pour des composants électroniques disposés sur des circuits imprimés selon la revendication 1, caractérisé en ce que chacune des barres peut être évidée et réalisée en un matériau souple pour la rendre éventuellement non rectiligne.

4. Systéme de positionnement à barres de types magnétique notamment pour des composants électroniques disposés sur des circuits imprimés selon la revendication 1, caractérisé en ce que le socle ferromagnétique (2) est en acier et amovible pour constituer un plateau indépendant.

5. Systéme de positionnement à barres de types magnétique notamment pour des composants électroniques disposés sur des circuits imprimés selon la revendication 1, caractérisé en ce que le repérage de positionnement des barres est prémarqué sur le socle (2) à l'aide de repéres (10).

**Patentansprüche**

1. System zum Einrichten von Stäben Typ magnetisch auf einem ferromagnetischen Sockel, insbesondere für elektronische Bauteile auf gedruckten Schaltkreisen, dadurch gekennzeichnet, daß es mindestens 2 Stäbe (1.1, 1.2...) aufweist, die einerseits seitliche Absätze (3.1, 3.2) aufweisen, die zur Aufnahme der seitlichen Seiten von mindestens einem Schaltkreis (4) bestimmt sind und andererseits eine Sohle aufweisen, die sich auf derjenigen Seite befindet, die derjenigen gegenüberliegt, auf der sich die Absätze befinden, und das eine magnetische Haltevorrichtung (9) darstellt, die die magnetische Halterung auf einem ferromagnetischen Sockel gewährleisten (2).

2. System zum Einrichten von Stäben Typ magnetisch, insbesondere für elektronische Bauteile auf gedruckten Schaltkreisen nach Anspruch 1, dadurch gekennzeichnet, daß jeder Stab (1...) die magnetische Vorrichtung (9) selbstklebend aufnimmt, wenn er in Form eines Bandes vorliegt.

3. System zum Einrichten von Stäben Typ magnetisch, insbesondere für elektronische Bauteile auf gedruckten Schaltkreisen nach Anspruch 1, dadurch gekennzeichnet, daß jeder Stab (1...) ausgehöhlt und aus einem weichen Werkstoff hergestellt werden kann, um ihn ggf. nicht geradlinig zu gestalten.

4. System zum Einrichten von Stäben Typ magnetisch, insbesondere für elektronische Bauteile auf gedruckten Schaltkreisen nach Anspruch 1, dadurch gekennzeichnet, daß der ferromagnetische Sockel (2) aus Stahl und abnehmbar ist, um eine unabhängige Platte zu bilden.

5. System zum Einrichten von Stäben Typ magnetisch, insbesondere für elektronische Bauteile auf gedruckten Schaltkreisen nach Anspruch 1, dadurch gekennzeichnet, daß die Kennzeichnung der Stäbe (1...) auf dem Sockel (2) mit Hilfe von Markierungen (10) vorab gekennzeichnet ist.

**Claims**

1. Clad magnetic bar positioning system on a ferromagnetic base particularly for electronic components arranged on printed circuits, characterised by the fact that it comprises at least two bars (1.1, 1.2...) fitted, firstly, with lateral redands (3.1, 3.2) designed to support the lateral sides of at least one printed circuit (4) and secondly, a sole plate placed on the side opposite to that comprising the redants and forming a magnetic application device (9) which ensures magnetic subjection on a ferromagnetic base (2).

2. Magnetic bar positioning system particularly for electronic components arranged on printed circuits according to patent claim 1, characterised by the fact that each bar (1...) supports the magnetic device (9) through self-adhesion when it takes the form of a strip.

3. Magnetic bar positioning system particularly for electronic components arranged on printed circuits according to patent claim 1, characterised by the fact that each bar (1...) can be hollowed and constructed from flexible material in order to make it non-rectilinear if necessary.

4. Magnetic bar positioning system particularly for electronic components arranged on printed circuits according to patent claim 1, characterised by the fact that the ferromagnetic base (2) is made from steel and can be removed in order to form a separate plate.

5. Magnetic bar positioning system particularly for electronic components arranged on printed circuits according to patent claim 1, characterised by the fact tha the bar position locater (1...) is pre-marked on the base (2) with the aid of marks (10).

EP 0 178 225 B1

_Fig. 1_

_Fig. 2_

1